**Europäisches Patentamt**

(19) **European Patent Office**

**Office européen des brevets**

(11) Veröffentlichungsnummer: **0 009 572**
**B1**

# (12) EUROPÄISCHE PATENTSCHRIFT

(45) Veröffentlichungstag der Patentschrift:
30.12.81

(51) Int. Cl.³: **G 06 F 11/26**, G 11 C 29/00

(21) Anmeldenummer: **79102845.9**

(22) Anmeldetag: **07.08.79**

(54) **Verfahren und Anordnung zur Prüfung von durch monolithisch integrierte Halbleiterschaltungen dargestellten sequentiellen Schaltungen.**

(30) Priorität: **30.09.78 DE 2842750**

(43) Veröffentlichungstag der Anmeldung:
**16.04.80 Patentblatt 80/8**

(45) Bekanntmachung des Hinweises auf die Patenterteilung:
**30.12.81 Patentblatt 81/52**

(84) Benannte Vertragsstaaten:
**DE FR GB**

(56) Entgegenhaltungen:
**US-A-3 675 200**
**US-A-3 761 695**

(73) Patentinhaber: **International Business Machines Corporation, Armonk, N.Y. 10504 (US)**

(72) Erfinder: **Hajdu, Johann, Bergamastrasse 77, D-7030 Böblingen (DE)**
Erfinder: **Knauft, Günter, Bergamastrasse 25, D-7030 Böblingen (DE)**

(74) Vertreter: **Busch, Robert, Dipl.-Ing., Schönaicher Strasse 220, D-7030 Böblingen (DE)**

## Verfahren und Anordnung zur Prüfung von durch monolithisch integrierten Halbleiterschaltungen dargestellten sequentiellen Schaltungen

Die Erfindung betrifft eine Anordnung, wie sie dem Oberbegriff des Patentanspruchs 1 zu entnehmen ist.

Mit den in zunehmendem Masse zur Verfügung stehenden hochintegrierten Schaltungsanordnungen in Form von aus einzelnen Halbleiterscheibchen aufgebauten Modulen wächst natürlich auch entsprechend dem höheren Integrationsgrad die Schwierigkeit, fehlerhaft gefertigte Halbleiterschaltungen erfassen zu können. Dies gilt um so mehr, wenn in den durch Halbleiterschaltungen dargestellten Funktionseinheiten neben Schaltgliedern bzw. Schaltnetzen, also Kombinationsschaltungen, auch eine mehr oder weniger grosse Anzahl von Speichergliedern, also sequentielle Schaltungen, enthalten ist.

Eine Möglichkeit zur Erfassung von minimalen austauschbaren Baueinheiten, die fehlerhafte Speicherglieder enthalten, könnte darin bestehen, dass jeder minimalen austauschbaren Einheit ein besonderer Prüfleitungsanschluss zugeordnet wird, so dass dann der betreffende Prüfleitungsanschluss zur Fehleranzeige bei Einzelprüfung herangezogen werden kann. Derartige Massnahmen verbieten sich jedoch, da hierdurch nicht nur eine unzulässig hohe Anzahl zusätzlicher Anschlussstellen vorgesehen werden müsste, die einen entsprechenden Platzbedarf erfordern, der bei hohem Integrationsgrad nicht ohne weiteres zur Verfügung steht, sondern auch infolge der hierbei erforderlichen Einzelprüfung der Zeitaufwand zur Prüfung nicht unbeträchtlich wäre. Hinzu kommt, dass bei Prüfung von hochintegrierten Halbleiterschaltungen mit hierin enthaltenen Schaltwerken eine Funktionsprüfung bzw. bei Zusammenfassung zu Schieberegistern eine Durchgangsprüfung nicht so ohne weiteres möglich ist, da hierzu und zur klaren Fehlererkennung die jeweiligen Speicherzustände im Vorhinein bekannt sein müssen. Mit anderen Worten, bevor eine Funktionsprüfung überhaupt durchgeführt werden soll, müssen zunächst die Speicherglieder in bekannte Zustände gesetzt oder die Zustände ermittelt werden.

Dies kann gemäss einer Prüfvorrichtung, wie sie der deutschen Offenlegungsschrift 23 49 324, entsprechend der US-Patentschrift 3 761 695, zu entnehmen ist, deren Beschreibung durch dieses Zitat in vorliegende Beschreibung eingeschlossen sein soll, dadurch erfolgen, dass zunächst ein Prüfmuster in derartige monolithisch integrierte Halbleiterschaltungen eingebracht wird. Dies setzt natürlich voraus, dass vorab die zu prüfende Funktionseinheit, speziell zur Prüfung, von einem Schaltwerk auf ein Schaltnetz, also von einer sequentiellen Schaltung in eine kombinatorische Schaltung umgesetzt wird. Jedes Speicherglied ist dabei zu einer Schieberegisterstufe, enthaltend ein Master-Kippglied und ein Slave-Kippglied, ausgeweitet; wobei die Kippglieder als solche mit Halteeingängen versehen sind, also als Verriegelungsschaltungen wirken. Alle Speicherglieder einer zu prüfenden Funktionseinheit lassen sich zu einem, in einzelne Segmente aufgeteilten Schieberegister zusammenfassen, wobei die Schieberegistersegmente als minimale austauschbare Einheiten angesehen werden können.

Die Prüfung erstreckt sich zunächst auf die Schieberegisterfunktion, um festzustellen, ob das Schieberegister richtig arbeitet. Wird hierbei kein Fehler festgestellt, dann erfolgt die Stufenanzahlempfindlichkeitsprüfung (level sensitive control). Hierzu werden alle Schieberegisterstufen in einen bestimmten bekannten Zustand gesetzt, um damit alle Auswirkungen der Speichervorgeschichte auszuschalten. Zur Durchführung einer gründlichen Prüfung müssen jedoch mehrere hundert Prüfmuster, d. h. Zustandskombinationen der Schieberegisterstufen angewendet werden, so dass hierdurch, wie gesagt, ein nicht unbeträchtlicher Aufwand bedingt ist. Entsprechend umständlich und schwierig ist es dann auch, ein spezielles Segment, also eine minimale austauschbare Einheit zu erfassen, das eine Fehlerursache in sich birgt.

Die präzise Feststellung und damit verbunden, die Möglichkeit zum Auswechseln eines fehlerhaften Segmentes wird aber angestrebt, da sich hiermit Betrieb und Wartung einer komplexen Anlage wesentlich erleichtern lassen. Um dies in einfachster Weise erreichen zu können, müssten aber zusätzliche Schaltungskomponentenanschlüsse und Leitungsmetallisierungen vorgesehen werden, die bei einer hochintegrierten monolithischen Halbleiterschaltung jedoch zu einem nicht unbeträchtlichen zusätzlichen Aufwand führen würden. Hierunter fallen insbesondere Anschlussstifte und der hierdurch bedingte Platzbedarf auf einem Modul oder Chip ins Gewicht, wenn zudem berücksichtigt wird, dass das ganze Trachten bei der hochintegrirten Halbleiterschaltungstechnik dahin geht, das Verhältnis von Anschlussstiftanzahl zu Schaltkreisanzahl möglichst klein zu halten. Das ist aber, wie gesagt, nicht möglich, wenn eine Fehlereingrenzung bis hinab zu einer minimalen austauschbaren Einheit mittels der bekannten Massnahmen erfolgen soll.

Die Aufgabe der Erfindung besteht darin, ein durch Vereinfachung verbessertes Prüfungsverfahren und eine vorteilhafte Anordnung hierzu bereitzustellen, wobei monolithisch integrierte Halbleiterschaltungen, jeweils bestehend aus mehreren minimalen austauschbaren Einheiten, einer Prüfung unterzogen werden sollen, um fehlerhafte minimale austauschbare Einheiten zu identifizieren, ohne dass ein nennenswerter zusätzlicher Aufwand in Form von Leitungszügen, Anschlussstiften, Schaltungskomponenten und dergleichen vorgesehen werden muss. Erfindungsgemäss wird dies erreicht, wie es dem Kennzeichen des Patentanspruchs 1 zu entnehmen ist.

Für die Erfindung ist es demnach bedeutsam, dass einmal zur Vorbereitung des Durchlauftests einer zur Prüfung zu einem Schieberegister zusammengefassten Halbleiterschaltung jeweils die beiden ersten Schieberegisterstufen jeder minimalen austauschbaren Einheit, also eines Segments, in zueinander entgegengesetzte Schaltzustände gebracht werden, wobei diese Massnahme für die beiden ersten Schieberegisterstufen des ersten Segmentes überflüssig ist, um dann durch einfaches Abzählen beim Durchlauftest am Schiebeausgang ein fehlerhaftes Segment beim jeweiligen Auftauchen von Bitgleichheit für Bitwerte jeweils beider ersten Schieberegisterstufen erfassen zu können. Werden nämlich Schiebeimpulse auf das zur Prüfung voreingestellte und zusammengefasste Schieberegister übertragen, dann müssen am Schiebeausgang immer komplementäre Bitpaare auftreten, die den jeweils entgegengesetzten Schaltzuständen der beiden ersten Schieberegisterstufen in jeder minimalen austauschbaren Einheit entsprechen.

Tritt in irgendeinem der Schieberegistersegmente ein Durchlauffehler auf, dann entfällt an der entsprechenden Stelle jeder Schaltzustandswechsel, so dass während des Ausschiebens beim Eintreffen eines der genannten komplementären Bitpaare keinerlei Wirkung eintritt und infolgedessen auch am Schiebeausgang an dieser Stelle der Bitfolge kein Bitwertwechsel zu verzeichnen ist. Einfaches Abzählen der Ausgangsbits genügt dann, um das fehlerhafte Segment identifizieren zu können.

Zur Fehlereingrenzung läuft also die Erfindung darauf hinaus, am Schiebeausgang der Bitfolge darauf zu untersuchen, ob die jeweiligen Bitwerte für die ersten beiden Schieberegisterstufen der in der zu prüfenden monolithisch integrierten Halbleiterschaltung enthaltenen Segmente ungleich ist oder gleich ist, um dann bei hierdurch bedingter Fehleranzeige entsprechende Massnahmen zur Fehlerbehebung ergreifen zu können. Ist ein fehlerhaftes Segment ermittelt, dann wird nach dessen Ersatz durch ein neues Segment anschliessend die Segmentkette einer zweiten Durchlaufprüfung unterzogen, um eventuell darin noch enthaltene Durchlauffehler ebenfalls erfassen zu können, da sie ja durch die zuvor entdeckte Bitgleichheit nicht in Augenschein treten konnten. Das Verfahren wird jedenfalls solange fortgesetzt, bis mit Sicherheit alle fehlerhaften Segmente erfasst sein können.

Um die Erfindung durchführen zu können, sind lediglich ein zusätzlicher Anschlussstift und ein Prüfschaltnetz am Eingang jeder minimalen austauschbaren Baueinheit, also eines Segmentes, erforderlich, was gegenüber den sonst zu treffenden Massnahmen zur Fehlerbegrenzung auf ein Segment zu einer erheblichen Aufwandseinsparung führt. Wohlgemerkt, die Speicherglieder einer zu prüfenden Funktionseinheit sind lediglich zur Prüfung der Betriebsbereitschaft als Schieberegister zusammengefasst; normalerweise sind jedoch die Speicherglieder je für ihren vorgesehenen Zweck zu verwenden bzw. zu betreiben.

Der für eine derartige Prüfung sonst erforderliche zusätzliche und, wie gezeigt, nicht unerhebliche Aufwand wird dank der Erfindung erheblich herabgedrückt. Dies ist insbesondere dann von Vorteil, wenn die Segmente und Funktionseinheiten sich im Verband einer grösseren Packungshierarchie befinden, bei der sich dann zusätzliche Anschlussstifte und Leitungsmetallisierungen entsprechend multiplizieren würden, so dass, dank der Erfindung lediglich ein einziger zusätzlicher Anschlussstift pro Segment erforderlich wird, dürfte selbst bei grösster Packungshierarchie keine nennenswerte Schwierigkeit zu verzeichnen sein.

Wenn auch die zur Durchführung der Erfindung zu einem Schieberegister zusammenfassbaren Speicherglieder als jeweilige Funktionseinheit mit Haupt- und Zwischenspeicherglied in jeglicher bekannter Bauart ausgeführt sein können, so hat es sich doch als vorteilhaft erwiesen, wenn die in einer zu prüfenden minimalen austauschbaren Baueinheit enthaltenen Speicherglieder, jeweils unter Hinzufügen eines Slave-Kippgliedes, als Master-Kippglied verwendet werden. Ausserdem ist es für die Erfindung an sich auch unbeachtlich, ob jeweils die beiden ersten Schieberegisterstufen einer minimalen austauschbaren Baueinheit über Parallel- oder Serieneingabe in den jeweils entgegengesetzten Schaltzustand gebracht werden. Gemäss einer vorteilhaften Weiterbildung der Erfindung jedoch ist der Serieneingabe zur Umschaltung der beiden ersten Schieberegisterstufen eines jeweiligen Segmentes erfindungsgemäss der Vorzug gegeben.

Die zur Fortschaltung der Master- und Slave-Kippglieder erforderlichen Master- und Slave-Taktimpulse brauchen nicht unbedingt von aussen über gesonderte Leitungen zugeführt zu werden, sondern lassen sich in vorteilhafter Weise auch aus den jeweils zugeführten, zur Umschaltung der beiden ersten Schieberegisterstufen jedes Segments zugeführten Prüfeinstellimpulse ableiten, wenn nur hierzu dem jeweiligen Prüfschaltnetz ein entsprechendes Schaltwerk zugeordnet wird. Da die erforderlichen Massnahmen an sich bekannt sind, genügt es, hier darauf hinzuweisen, dass z.B. eine entsprechende Multivibratorkette zur Auslösung durch die Prüfeinstellimpulse vorgesehen werden kann.

Schliesslich sind gemäss der Erfindung aus der an sich denkbaren Anzahl von Möglichkeiten zur seriellen Eingabe der Prüfeinstellimpulse zur Umschaltung der beiden ersten Schieberegisterstufen eines jeden Segmentes zur Durchführung der Erfindung in besonders vorteilhafter Weise zwei verschiedene Verfahren bevorzugt ausgewählt. So wird gemäss dem ersten bevorzugten Ausführungsbeispiel das Prüfschaltnetz am Eingang jedes Segmentes zur Abfühlung des jeweils vor Zuführung der Prüfeinstellimpulse vorliegenden Schaltzustandes der jeweiligen ersten Schieberegisterstufe ausgebildet, so dass bei Zuführung eines Prüfeinstellimpulses sowie der Master- und Slave-Taktimpulse der dem Schaltzustand der ersten Schieberegisterstufe entsprechende Bitwert auf die zweite Schieberegisterstufe übertragen und in die erste Schieberegisterstufe der hierzu komplementäre Bitwert eingesetzt wird. Im zweiten bevorzugten Ausführungsbeispiel wird unabhängig von der Vorgeschichte der jeweils beiden ersten Schieberegisterstufen zunächst in die erste Schieberegisterstufe ein vorgegebener Bitwert durch entsprechende Zuführung eines Prüfeinstellimpulses in Koinzidenz mit einem Master-Taktimpuls zugeführt. Dieser in die erste Schieberegisterstufe eingegebene Bitwert wird dann bei Auftreten des zweiten Master-Taktimpulses in die zweite Schieberegisterstufe unter gleichzeitiger Zuführung eines hierzu komplementären Bitwerts in die erste Schieberegisterstufe übertragen.

Weitere vorteilhafte Ausgestaltungen und Weiterbildungen der Erfindung lassen sich den Unteransprüchen entnehmen.

Die Erfindung wird anschliessend anhand einer Ausführungsbeispielsbeschreibung mit Hilfe der unten aufgeführten Zeichnungen näher erläutert.

Es zeigen:

Fig. 1 eine Funktionseinheit in Form eines Hierarchieverbandes mit erfindungsgemäss ausgestatteten Schieberegistersegmenten und den erforderlichen Ansteuerungs- und Betriebsleitungen;

Fig. 2 ein Blockschaltbild eines Schieberegistersegmentes mit Prüfschaltnetz zur Durchführung der ersten Betriebsart gemäss der Erfindung.

Fig. 3 ein gegenüber vorher modifiziertes Prüfschaltnetz zur Durchführung der zweiten Betriebsart gemäss der Erfindung;

Fig. 4 Impulsdiagramme zur Erläuterung der ersten Betriebsart gemäss der Erfindung.

Fig. 5 Impulsdiagramme zur Erläuterung der zweiten Betriebsart gemäss der Erfindung.

Fig. 6 ein Schema mit Legende zur Erläuterung des Fehlereingrenzungsverfahrens gemäss der Erfindung.

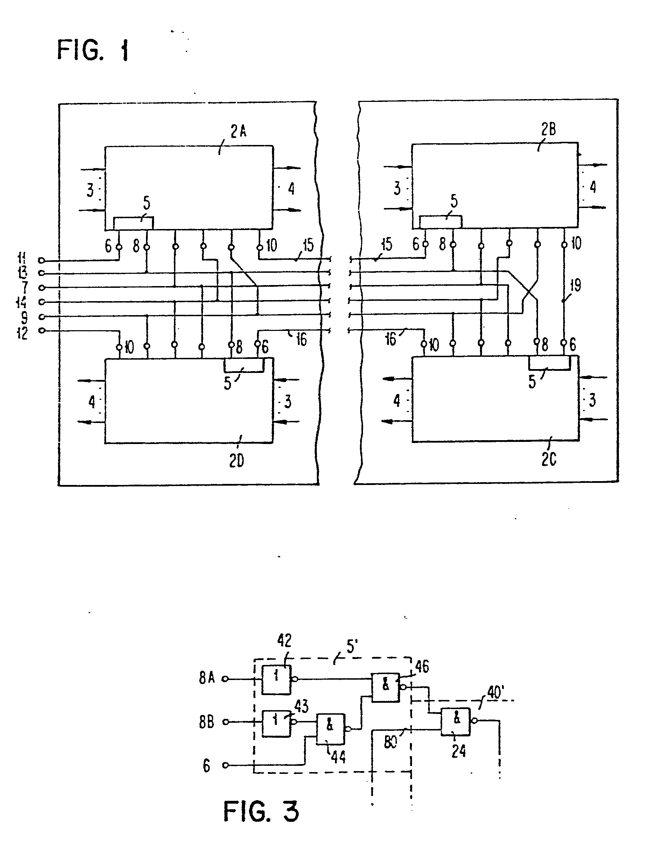

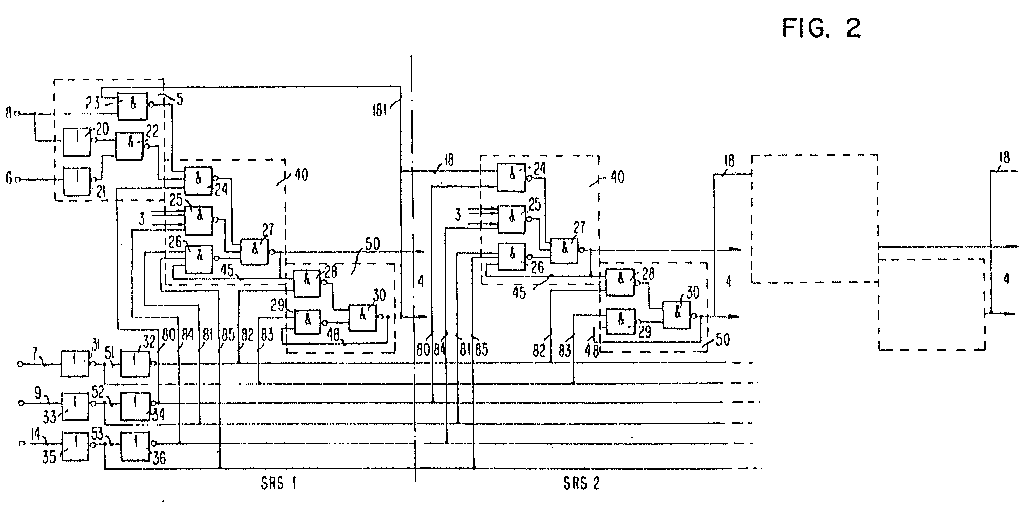

Beim in Fig. 1 gezeigten Hierarchieverband befinden sich auf einem Schaltkärtchen, einem Modul und dergleichen die minimalen austauschbaren Baueinheiten in Form der Schieberegistersegmente 2A, 2B, 2C, 2D, die wie durch die Bruchlinien angedeutet, in grösserer Anzahl vorgesehen sein können. Es ist auch nicht unbedingt davon auszugehen, dass nur zwei Schieberegistersegmentzeilen übereinander anzubringen sind, sondern es kann vielmehr auch eine matrixartige Anordnung der Schieberegistersegmente vorgesehen werden, indem die einzelnen Zeilen und Spalten dann jeweils eine grössere Anzahl von Schieberegistersegmenten enthalten können. Im übrigen brauchen die Schieberegistersegmente nicht in regelmässiger Anordnung auf den jeweiligen Substraten vorgesehen zu sein. Die Segmente selbst können in Form von Halbleiterchips, Modulen, Schaltkärtchen usw. vorliegen, wobei allerdings in jedem Falle hierdurch minimale austauschbare Baueinheiten in einem grösseren Hierarchieverband dargestellt werden sollen. Die derartige Schieberegistersegmente tragenden Substrate stellen im Hierarchieverband die jeweils übergeordnete Einheit dar.

Auf dem die Schieberegistersegmente 2A, 2B, 2C, 2D tragenden Substrat in Fig. 1 sind fernerhin die Leitungszüge 11 als Schiebeeingangsleitung, 13 als Prüfimpulsleitung, 7 als Slave-Taktimpulsleitung, 14 als Systemtaktimpulsleitung, 9 als Master-Schiebetaktimpulsleitung, 12 als Schiebeausgangsleitung, 15, 16 und 19 als Schiebeverbindungsleitungen aufgebracht, die sämtlich zur erfindungsgemässen Durchführung der Funktionsprüfung erforderlich sind. Bei jedem Schieberegistersegment 2A, 2B, 2C, 2D sind ausserdem noch die zur Ansteuerung der in den einzelnen Schieberegistersegmenten enthaltenen Speicherglieder vorgesehenen Leitungsgruppen 3 und die Speicherglieder-Ausgangsleitungsgruppen 4 angedeutet. Über diese Leitungszüge sollen beim vorgesehenen Verwendungszweck der Funktionseinheiten jeweils die einzelnen Speicherglieder in den gewünschten Zustand gesetzt werden, um dann Ausgangsgrössen zur weiteren Verwendung bzw. Nutzung liefern zu können. Ein näheres Eingehen hierauf erübrigt sich, da dies ohne Belang für die Erfindung ist.

Die oben aufgeführten Leitungszüge sind in Fig. 1 je schematisch eingezeichnet, wobei es für die Erfindung dann bedeutungslos ist, wie ihr Verlauf im einzelnen ist, d. h., ob sich die Anschlüsse hierzu links, rechts, oben oder unten auf dem Substrat befinden. Dies hängt im einzelnen von der Substratauslegung (Design) und von der vorgesehenen Lage der Schieberegistersegmente 2A, 2B, 2C und 2D ab. Jedes der Schieberegistersegmente 2A, 2B, 2C und 2D enthält einen Block 5, der zur Andeutung des Prüfschaltnetzes dient, das mit seiner Anschlussklemme 6 an der jeweiligen Schiebe- 11 bzw. Schiebeverbindungsleitung 15, 16, 19 und mit seiner Klemme 8 an der Prüfeinstellimpulsleitung 13 liegt. Die jeweilige Ausgangsklemme 10 der Schieberegistersegmente 2A, 2B, 2C und 2D liegt entsprechend ebenfalls an den genannten Schiebeverbindungsleitungen 15, 16, 19 bzw. an der Schiebeausgangsleitung 12.

Unter der Wirkung des Prüfschaltnetzes 5 lassen sich bei Übertragung eines Prüfeinstellimpulses gemäss der Erfindung über die Prüfeinstellimpulsleitung 13 Einstellimpulse für die jeweiligen beiden ersten Schieberegisterstufen der hintereinandergeschalteten Schieberegistersegmente 2A, 2B, 2C und 2D zuführen, so dass jeweils die beiden ersten Schieberegisterstufen in zueinander entgegengesetzten Schaltzustand gebracht werden können und bei anschliessendem Schiebebetrieb die über die Verbindungsleitungen 15, 19 und 16 zu einem einzigen Schieberegister hintereinandergeschalteten Schieberegistersegmente 2A, 2B, 2C und 2D bei Fehlerfreiheit eine Bitfolge übertragen, die an der Schiebeausgangsleitung 12 die jeweiligen Zustandswechsel bei den ersten beiden Schieberegisterstufen aller Schieberegistersegmente erkennen lässt. Zeigt sich demgegenüber jedoch in der Bitfolge am Schiebeausgang ab einer bestimmten
Bitanzahl kein derartiger Bitwertwechsel, dann
lässt sich dies als klarer Hinweis auf ein fehlerhaftes Schieberegistersegment nehmen, so dass bei
jeweils bekannten Speichergliedanzahl in den
einzelnen Schieberegistersegmenten 2A, 2B, 2C
und 2D durch einfaches Abzählen der Bits zu der
in Erscheinung tretenden Sprungstelle in der Bitfolge das fehlerhafte Schieberegistersegment zu
bestimmen ist; es kann dann repariert oder ausgewechselt werden.

Die Bitfolgenprüfung am Schiebeausgang läuft
also in gewisser Weise darauf hinaus, dass jeweils nach bestimmter Bitanzahl in der Bitfolge,
festgelegt durch die jeweilige Anzahl der Schieberegisterstufen in den einzelnen Schieberegistersegmenten, auf Bitwertgleichheit bzw. -ungleichheit untersucht wird. Wird Bitgleichheit
festgestellt, dann liegt ein Durchlauffehler vor,
der, wie gesagt, die betreffenden Massnahmen
auslöst. Eine derartige Bitwertgleichheitsprüfung
lässt sich mit Hilfe eines entsprechend zählergesteuerten Vergleichers durchführen, wobei dann
das Vergleichersignal zur Fehleranzeige herangezogen werden kann.

Ist in einer Schieberegister-Segmentfolge auf
diese Weise ein fehlerhaftes Segment ermittelt
worden, dann kann allerdings noch offen bleiben,
ob nicht noch irgendeines der nachfolgenden
Segmente der betreffenden Schieberegister-
Segmentfolge einen Durchlauffehler enthält, da
ein derartiger Fehler durch die bereits durch den
erfassten Fehler bedingte Bitwertgleichheit in der
Bitfolge am Schiebeausgang überdeckt wird.
Zweckmässigerweise wird deshalb nach Erfassung eines fehlerhaften Segments anschliessend
der diesem Segment folgende Teil der Schieberegister-Segmentfolge ebenfalls noch einer Prüfung unterzogen, indem zuvor das fehlerhafte
Segment durch ein neues ersetzt wird, um dann
die gesamte Schieberegister-Segmentfolge erneut zu prüfen. Dieser Vorgang wird wiederholt,
bis feststeht, dass die betreffende Schieberegistersegmentfolge vollständig der Durchlaufprüfung unterzogen worden ist.

Die in den einzelnen Schieberegistersegmenten 2A, 2B, 2C und 2D enthaltenen Speicherglider können von jeder üblichen Bauart sein, jedoch ist es notwendig, dass jedem Speicherglied
zusätzlich zumindest ein Zwischenspeicherglied
zugeordnet wird, damit sich bei Hintereinanderschaltung, z.B. über ODER-Glieder, ein Schieberegister aufbauen lässt. Die Hintereinanderschaltung der so gebildeten Schieberegisterstufen erfolgt also über Schaltglieder, die so steuerbar
sind, dass nur für Prüfungszwecke eine Hintereinanderschaltung der in der zu prüfenden minimalen austauschbaren Baueinheit vorhandenen
Speicherglieder stattfinden kann, so dass beim
vorgesehenen Verwendungszweck der Speicherglieder hingegen deren ungestörte und unabhängige Betriebsweise gewährleistet ist. Abgesehen
davon können sich die einzelnen Speicherglieder
einer zu prüfenden minimalen austauschbaren Baueinheit jeweils noch in einem grösseren Verband von Schaltwerken, nämlich Kombinationsschaltungen zusammen mit sequentiellen Schaltungen befinden, d. h., es können noch zusätzlich
für den vorgesehenen Verwendungszweck erforderliche Schaltglieder in den minimalen austauschbaren Baueinheiten, die hier, wie gesagt,
als Schieberegistersegmente vorliegen, vorhanden sein. Da sie doch zur Erläuterung der Erfindung nicht von Bedeutung sind, ist im Blockschaltbild nach Fig. 2 auch nur eine reine
Speichergliedbetriebsschaltung, bzw. sequentielle Schaltung, gezeigt, um so Übersichtlichkeit
und Klarheit der Darstellung zur Erläuterung der
Erfindung zu gewährleisten.

Obgleich die Erfindung mit jeder beliebigen
Schieberegisterstufenausbildung zu betreiben
ist, sei hier jedoch die Master-Slave-Kippgliedkonfiguration, die mit Hilfe der in Fig. 2 dargestellten Verriegelungsschaltungen 40 und 50 realisiert ist, im einzelnen näher beschrieben. Die als
Master-Kippglied dienende Verriegelungsschaltung 40 besteht aus den vier NAND-Gliedern 24,
25, 26 und 27, wovon die drei erstgenannten 24,
25 und 26 das zuletzt genannte NAND-Glied 27
ansteuern, von dessen Ausgang hin wiederum zu
einem Eingang des NAND-Gliedes 26 eine Halteleitung als Rückkopplungsleitung 45 vorgesehen
ist, so dass der von dem Master-Kippglied 40 eingenommene Zustand jeweils verriegelt wird. Im
einzelnen erhalten die drei Eingänge des NAND-
Gliedes 26 über Leitung 81 einen invertierten Master-Taktgebungsimpuls, über Leitung 85 einen
invertierten Systemtaktimpuls und, wie gesagt,
über Rückkopplungsleitung 45 den Ausgangsimpuls des nachgeschalteten NAND-Gliedes 27. Ein
zweiter Eingang des NAND-Glieds 27 liegt am
Ausgang des NAND-Glieds 25, dessen Eingänge
über Leitungen 3 für Datenverarbeitungsbetriebsweise vorgesehen sind, indem über Leitung
84 noch der Systemtaktimpuls zugeführt wird.
Der dritte Eingang des NAND-Glieds 27 liegt am
Ausgang eines dritten NAND-Glieds 24, dessen
Eingänge über Leitung 80 den Master-Taktgeberimpuls und über eine weitere Leitung den Schiebeimpuls erhält.

Mit dem Ausgang des NAND-Glieds 27 und damit mit der Rückkopplungsleitung 45 steht der
Steuereingang des Slave-Kippgliedes 50 in Verbindung, das selbst aus den drei NAND-Gliedern
28, 29 und 30 aufgebaut ist. Im einzelnen ist der
Ausgang des NAND-Glieds 28 mit einem Eingang
des NAND-Glies 30 verbunden, dessen zweiter
Eingang am Ausgang des NAND-Glieds 29 liegt.
Der Ausgang des NAND-Gliedes 30 ist über Leitung 48 mit einem Eingang des NAND-Gliedes 29
verbunden, dessen zweiter Eingang über Leitung
83 einen invertierten Slave-Taktgeberimpuls erhält. Über Leitung 82 wird dem NAND-Glied 28 an
seinen zweiten Eingang der Slave-Taktgeberimpuls zugeführt, wobei der andere Eingang dieses
NAND-Gliedes 28 an den Ausgang des NAND-
Gliedes 27 des Master-Kippgliedes 40 angeschlossen ist.

Obwohl an sich nicht erforderlich und wohl auch nicht üblich, sei zur Vereinfachung der Erläuterung der Erfindung vorausgesetzt, dass alle Schieberegisterstufen in den Schieberegistersegmenten genau den gleichen Aufbau besitzen. Die Ausgangsleitungsgruppe 4 einer jeweiligen Schieberegisterstufe setzt sich aus Leitungen zusammen, die, wie in Fig. 2 gezeigt, jeweils an den Ausgang der Kippglieder 40 und 50 und gegebenenfalls noch, wie hier nicht weiter gezeigt, an zusätzliche ODER-Glieder angeschlossen sind, deren Eingänge mit den verschiedensten Punkten in den Master- und Slave-Kippgliedern 40 und 50 in Verbindung stehen können.

Die Master-Taktgebungsimpulse werden über Leitung 9, die Slave-Taktgebungsimpulse über Leitung 7 und die Systemtaktgebungsimpulse über Leitung 14 zugeführt, wobei in jeder Taktgeberimpulsleitung je zwei hintereinandergeschaltete NICHT-Glieder 33, 34, 31, 32, 35, 36 vorgesehen sind, deren jeweilige Verbindungsleitungen 51, 52 bzw. 53 mit zusätzlichen Taktgeberimpulsleitungen zur Bereitstellung invertierter Master-Taktgebungs-, Slave-Taktgebungs- und Systemtaktgebungsimpulsen verbunden sind. So enthält die Slave-Taktgebungsimpulsleitung 7 das NICHT-Glied 31, das über Verbindungsleitung 51 mit dem NICHT-Glied 32 in Verbindung steht, dessen Ausgang an die Leitung 82 angeschlossen ist, wohingegen die Verbindungsleitung 51 mit der Leitung 83 verbunden ist. Die Master-Taktgebungsimpulsleitung 9 liegt am Eingang des NICHT-Gliedes 33, das über Verbindungsleitung 52 mit NICHT-Glied 34 in Verbindung steht, dessen Ausgang hinwiederum an die Leitung 80 angeschlossen ist. Die Verbindungsleitung 52 selbst liegt an der Zuleitung 81. Die Systemtaktgebungsimpulsleitung 14 liegt am Eingang des NICHT-Gliedes 35, dessen Ausgang über Verbindungsleitung 53 am Eingang des NICHT-Gliedes 36 liegt. Während der Ausgang des NICHT-Gliedes 35 mit der Zuleitung 85 in Verbindung steht, liegt der Ausgang des NICHT-Gliedes 36 an der Leitung 84. Die Taktgebungsimpulseingänge der übrigen Schieberegisterstufen eines Schieberegistersegmentes liegen über ihren jeweils zugeordneten Leitungen 80 bis 85 in entsprechender Weise an den Ausgängen der NICHT-Glieder 31 bis 36.

Der Ausgang des NAND-Gliedes 30 im Slave-Kippglied 50 einer Schieberegisterstufe liegt über Leitung 18 jeweils am Steuereingang der nächstfolgenden Schieberegisterstufe, nämlich am betreffenden Eingang des NAND-Gliedes 24 im betreffenden Master-Kippglied 40. Da letzte Schieberegisterstufe eines Schieberegistersegmentes weist somit also einen Schiebeausgang auf, der mit der Ausgangsleitung 18 der letzten Schieberegisterstufe hierin verbunden ist.

Der Schieberegisterbetrieb eines derart aufgebauten Schieberegisters wird in der Weise durchgeführt, dass bei Auftreten eines Schiebeimpulses am Eingang einer Schieberegisterstufe der Bitwert des Schiebeimpulses unter gleichzeitiger Wirkung eines Master-Taktgebungsimpulses in das Master-Kippglied eingegeben wird. Beim darauffolgenden Slave-Taktgebungsimpuls mit umgekehrter Polarität wird dann der Bitwert auf das Slave-Kippglied übertragen, dessen Ausgang im Zusammenwirken mit einem zweiten Master-Taktgebungsimpuls als Eingabegrösse für die darauffolgende Schieberegisterstufe dient. Im wesentlichen bestehen dabei die Master-Taktgebungs- und Slave-Taktgebungsimpulse aus Impulsfolgen, deren Phasenlage um 180° zueinander versetzt ist. Eine derartige Betriebsweise für Schieberegister ist an sich bekannt und braucht deshalb auch nicht weiter dargelegt zu werden.

Zur Durchführung der ersten Betriebsart für die erfindungsgemäss vorgenommene Prüfung, nämlich zur Einstellung des Schaltzustandes der ersten Schieberegisterstufe SRS1 in Abhängigkeit vom auf die zweite Schieberegisterstufe SRS2 übertragenen Bitwert, nämlich mit dessen Komplementärwert, ist eine Rückkopplungsleitung 181 vom Ausgang des Slave-Kippgliedes 50 bzw. seiner Ausgangsleitung 18 in der ersten Schieberegisterstufe SRS1 auf einen Eingang des Prüfschaltnetzes 5 vorgesehen. Das Prüfschaltnetz 5 besitzt einen weiteren Eingang mit Anschluss 6 zur Aufnahme der Schiebeimpulse und einen anderen Eingang über Anschluss 8 zur Zuführung der Prüfeinstellimpulse. Die Ausgänge des Prüfschaltnetzes 5 liegen an den Eingängen des NAND-Glieds 24 im Master-Kippglied 40 der ersten Schieberegisterstufe SRS1. Das Prüfschaltnetz 5 enthält zwei NAND-Glieder 22 und 23.

Das NAND-Glied 23 liegt mit einem Eingang an der Rückkopplungsleitung 181, währen der zweite Eingang mit dem Anschluss 8 in Verbindung steht. Das NAND-Glied 22 wird an seinen beiden Eingängen je über ein NICHT-Glied 20, 21 gespeist, wovon das eine an den Anschluss 8 zur Zuführung der Prüfeinstellimpulse und das andere mit dem Anschluss 6 zur Zuführung der Schiebeimpulse verbunden ist.

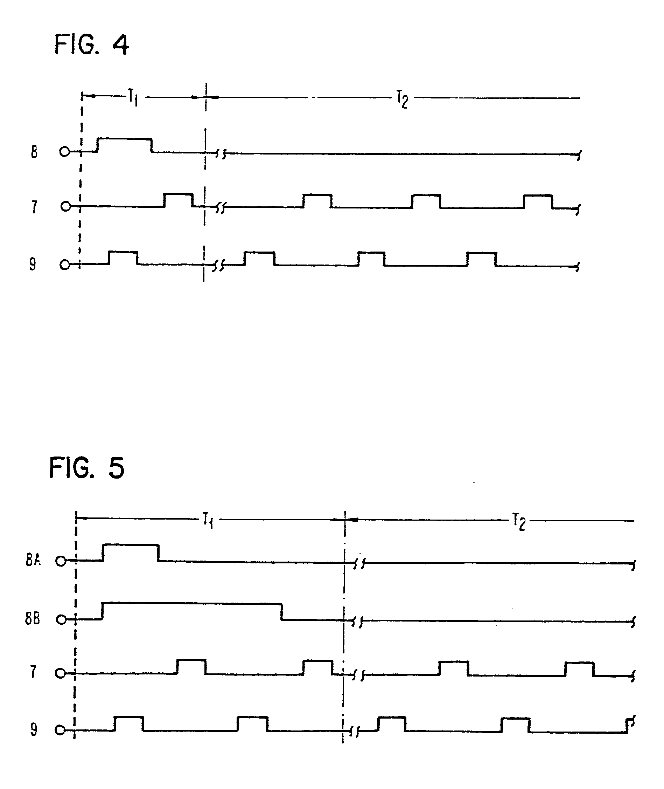

Unter Zuhilfenahme der Impulsdiagramme nach Fig. 4 lässt sich jetzt der erfindungsgemässe Zustandswechsel der beiden ersten Schieberegisterstufen SRS1 und SRS2 eines jeweiligen Schieberegistersegments bei Zuführung eines Prüfeinstellimpulses über Anschlussklemme 8 erläutern. Im Zeitraum $T_1$, der sich im wesentlichen über eine einzige Periode des Master-Taktgebungsimpulses erstreckt, so dass also hiervon nicht zwei Master-Taktgebungsimpulse erfasst werden, wird ein Prüfeinstellimpuls über Anschluss 8 gleichzeitig mit einem Master-Taktgebungsimpuls auf Master-Taktgebungsimpulsleitung 9 zugeführt. Die Zeitdauer des Prüfeinstellimpulses kann sich dabei über den gesamten Zeitraum $T_1$ erstrecken; sie ist dabei also grösser als die des Master-Taktgebungsimpulses auf Master-Taktgebungsimpulsleitung 9, indem der Prüfeinstellimpuls entsprechend früher einsetzt und später abklingt. Der Systemtaktgebungseingang über Leitung 14 erhält kein Signal.

Wird zunächst vorausgesetzt, dass der Eingang des NAND-Gliedes 30 im Slave-Kippglied 50 negativ ist, dann ist über Leitung 181 ein Eingang des NAND-Glieds 23 im Prüfschaltnetz 5 ebenfalls negativ, so dass unabhängig vom Anlegen eines Prüfeinstellimpulses an Anschluss 8 der Ausgang des NAND-Glieds 23 immer positiv ist. Jedoch es wird bei Zuführen eines Prüfeinstellimpulses ein negativer Impuls am Eingang des NAND-Glieds 22 wirksam, so dass dann auch der Ausgang des NAND-Glieds 22 positiv wird und somit gleichzeitig mit einem Master-Taktgebungsimpuls auf Master-Taktgebungsimpulsleitung 9 alle Eingänge des NAND-Glieds 24 im Master-Kippglied 40 positiv sind, dessen Ausgang im Ansprechen hierauf negativ wird. Bei einem negativen Eingang am NAND-Glied 27 ist dessen Ausgang positiv, so dass beim Zuführen eines Slave-Taktgebungsimpulses über Slave-Taktgebungsimpulsleitung 7 und anschliessend über Leitung 82 auf das NAND-Glied 28, dessen beide Eingänge positiv sind, auch dessen Ausgang negativ wird. Damit liegt ein negativer Eingang am NAND-Glied 30 des Slave-Kippgliedes 50 vor, so dass dessen Ausgang positiv wird. Wird berücksichtigt, dass mit Eingabe des Prüfeinstellimpulses über Anschluss 8 in das Prüfschaltnetz 5 und anschliessender Übertragung unter Wirkung des Master-Taktgebungsimpulses auf Master-Taktgebungsimpulsleitung 9 in das Master-Kippglied 40 der ersten Schieberegisterstufe SRS1 der ursprünglich auf der Ausgangsleitung 18 des Slave-Kippgliedes 50 der ersten Schieberegisterstufe SRS1 auftretende Pegel als negativ vorausgesetzt gewesen ist, dann ist ohne weiteres klar, dass der Zustand beider Schieberegisterstufen SRS1, SRS2 zueinander entgegengesetzt ist, da unter der Wirkung des Slave-Taktgebungsimpulses auf der Slave-Taktgebungsimpulsleitung 7 gleichzeitig auch der Zustand des Master-Kippglieds 40 in der zweiten Schieberegisterstufe SRS2 auf das Slave-Kippglied 50 der zweiten Schieberegisterstufe SRS2 übertragen worden ist. Somit ist das betreffende Schieberegistersegment zur Vornahme der eigentlichen Durchlaufprüfung vorbereitet.

Wird nun gegenüber zuvor vorausgesetzt, dass der Ausgang des NAND-Glieds 30 im Slave-Kippglied 50 positiv ist, dann liegt über Rückkopplungsleitung 181 an einem Eingang des NAND-Glieds 23 im Prüfschaltnetz 5 ein positiver Pegel, so dass bei Zuführen eines Prüfeinstellimpulses über Anschluss 8 auf den einen Eingang des NAND-Glieds 24 im Master-Kippglied 40 der ersten Schieberegisterstufe SRS1 ein negativer Pegel am Eingang liegt. Das hat zur Folge, dass für die Dauer des Prüfeinstellimpulses am Anschluss 8 am Ausgang des NAND-Glieds 24 positives Potential auftritt, so dass, wenn vorausgesetzt wird, dass kein Systemtaktimpuls anliegt, was ja beim Prüfungsvorgang als solchem in jedem Falle zutrifft, da dann ja auch kein Systembetrieb durchgeführt wird, auch der Eingang des NAND-Glieds 25 positiv ist. Der Ausgang des NAND-Glies 28 ist ebenfalls positiv, da, wie gesagt, erstens kein Systemtaktimpuls anliegt und zweitens in diesem Zeitraum erfindungsgemäss ja auch der Master-Taktgebungsimpuls auf Master-Taktgebungsimpulsleitung 9 anliegt, der über Inverter 33 über Verbindungsleitung 52 und Zuleitung 81 als negativer Eingang am NAND-Glied 26 bereitgestellt wird. Damit ist aber der Ausgang des NAND-Glieds 27 und gleichzeitig der Ausgang des Master-Kippglieds 40 negativ, so dass dann auch der Ausgang des NAND-Glieds 28 am Eingang des Slave-Glieds 50 positiv wird.

Da der Slave-Taktgebungsimpuls über Slave-Taktgebungsimpulsleitung 7, wie aus dem Diagramm der Fig. 4 ersichtlich, erst zu einem späteren Zeitpunkt zugeführt wird, erhält ein Eingang des NAND-Glieds 29 über Leitung 83 unter der Wirkung des NICHT-Glieds 31 positives Potential. Da der andere Eingang des NAND-Glieds 29 im Slave-Kippglied 50 durch den Ausgang des NAND-Glies 30 bereits positiv ist, kann dann das NAND-Glied 30 wirksam werden, so dass dessen Ausgang nunmehr in den negativen Zustand gelangt. Auch hier wiederum gilt wie zuvor entsprechend, dass der ursprünglich vorgelegene positive Schaltzustand im Slave-Kippglied 50, nämlich positiver Potentialpegel, gleichzeitig mit der Eingabe des Prüfeinstellungsimpulses unter der Einwirkung des Master-Taktgebungsimpulses auf der Master-Taktgebungsimpulsleitung 9 in das Master-Kippglied 40 der ersten Schieberegisterstufe SRS1 auf das Master-Kippglied 40 der zweiten Schieberegisterstufe SRS2 übertragen worden ist, so dass hierdurch ebenfalls entgegengesetzte Schaltzustände in den beiden ersten Schieberegisterstufen SRS1 und SRS2 des betreffenden Schieberegistersegmentes vorliegen.

Damit ist gezeigt, dass durch Zuführen eines Prüfeinstellimpulses über Anschlussklemme 8 auf das jeweilige Prüfschaltnetz 5 unabhängig vom jeweiligen Zustand des ersten Schieberegisterstufenpaares eines Schieberegistersegments ein jeweils entgegengesetzter Schaltzustand herbeiführbar ist. Dank der Erfindung lässt sich also in vorteilhafter Weise ohne grossen zusätzlichen Aufwand ein einfaches Prüfungsverfahren zur Feststellung fehlerhafter Segmente in einer hochintegrierten hierarchischen Struktur anwenden. Lediglich eine einzige weitere Anschlussklemme, nämlich die zur Zuführung der Prüfeinstellimpulse, ist hierzu erforderlich.

Wie bereits gesagt, stützt sich die Erfindung auch noch auf eine zweite bevorzugte Prüfungseinstellungsbetriebsart. Hierzu dient das in Fig. 3 gezeigte Prüfschaltnetz, dessen Wirkungsweise anhand der Impulsdiagramme nach Fig. 5 erläutert werden soll. Da bei dieser Betriebsart die Einstellung der beiden ersten Schieberegisterstufen SRS1 und SRS2 eines jeweiligen Schieberegistersegmentes ohne Berücksichtigung des jeweils vorhandenen Schaltzustandes, also unbeachtlich deren Vorgeschichte erfolgt, entfällt hier die Zuleitung 181 vom Ausgang des NAND-Glieds 30 im Slave-Kippglied (Fig. 2). Stattdessen werden hier zwei gleichzeitig einsetzende Prüfeinstellimpulse gesondert über die Anschlüsse 8A und 8B zugeführt, welche jedoch unterschiedlicher Dauer sind, nämlich derart, dass der am Anschluss 8A anliegende Prüfeinstellimpuls wie vorhin gleichzeitig mit dem Master-Taktgebungsimpuls auf Master-Taktgebungsimpulsleitung 9 anliegt und diesen in seiner Impulsdauer sowohl beim Einsetzen als auch beim Ausklingen überlappen kann, wobei wie vorhin nur darauf zu achten ist, dass dieser erste Prüfeinstellimpuls nicht zwei Mastertaktgebungsimpulse erfasst und dass der an Anschluss 8B anliegende Prüfeinstellimpuls zwei aufeinanderfolgende Master-Taktgebungsimpulse auf Master-Taktgebungsleitung 9 überlappt, ohne dass weitere Master-Taktgebungsimpulse hiervon erfasst werden.

Im vorliegenden Fall sind zur Vereinfachung der Erläuterung der Erfindung zwei getrennte Anschlussklemmen 8A und 8B vorgesehen; es kann aber vorteilhafterweise auch nur eine einzige Anschlussklemme zur Verfügung eines einzelnen Prüfeinstellimpulses vorgesehen werden, wobei dann der jeweils verlängerte Impuls über ein monostabiles Kippglied, das ebenfalls an die Anschlussklemme für die Zuführung des einzelnen Prüfeinstellimpulses angeschlossen ist, aus dem kürzeren Prüfeinstellimpuls abgeleitet wird, so dass dann einmal der ursprünglich zugeführte kürzere Prüfeinstellimpuls und zum anderen der vom monostabilen Kippglied abgeleitete verlängerte Prüfeinstellimpuls zur Verfügung steht.

Das gegenüber vorher abgewandelte Prüfschaltnetz 5′ besitzt nur einen Ausgang, der an einem entsprechend abgewandelten Master-Kippglied 40′ der ersten Schieberegisterstufe SRS1 eines Schieberegistersegmentes angeschlossen ist, nämlich wiederum am betreffenden Eingang seines NAND-Glieds 24, das in diesem Falle nur zwei Eingänge besitzt, nämlich den genannten und einen weiteren, der über Zuleitung 80 zur Zuführung der Master-Taktgebungsimpulse auf Master-Taktgebungsimpulsleitung 9 dient. Das Prüfschaltnetz 5′ enthält zwei NAND-Glieder 44, 46 und zwei NICHT-Glieder 42, 43. Im Gegensatz zu vorher jedoch ist das Ausgangs-NAND-Glied 46 des Prüfschaltnetzes 5′ mit seinem Eingang an den Ausgang des einen NICHT-Glieds 42 angeschlossen, dessen Eingang hinwiederum mit der Anschlussklemme 8A zur Zuführung des kurzen Prüfeinstellimpulses verbunden ist. Der andere Eingang des Ausgangs-NAND-Glieds 46 liegt am Ausgang des zweiten NAND-Glieds 44, dessen erster Eingang am Ausgang des NICHT-Glieds 43 liegt und dessen anderer Eingang mit der Anschlussklemme 6 zur Zuführung eines Schiebeimpulses verbunden ist. Der Eingang des zweiten NICHT-Glieds 43 ist an den Anschluss 8B zur Zuführung des verlängerten Prüfeinstellimpulses angeschlossen. Während bei der zuerst beschriebenen Betriebsart gemäss der Erfindung unter der Wirkung der Rückkopplungsleitung 181 zur Umschaltung beider ersten Schieberegisterstufen eines Schieberegistersegmentes die bereits vorhandenen Zustände ins Spiel kommen, so dass sichergestellt ist, dass mit einem zugeführten Prüfeinstellimpuls ein jeweils entgegengesetzter Schaltzustand in beiden Schieberegisterstufen SRS1 und SRS2 herbeigeführt wird, ist die Vorgeschichte bei der zweiten, gemäss der Erfindung bevorzugten Betriebsart unbeachtlich, so dass die Zustandsabtastung von Schieberegisterstufen hierbei entfällt.

Wird zur Vorbereitung der Prüfung ein Prüfeinstellimpuls an Anschluss 8A angelegt, dann ist der Eingang des NAND-Glieds 46 unter der Wirkung des NICHT-Gliedes 42 negativ. Damit wird ein positiver Ausgang am NAND-Glied 46 herbeigeführt, so dass auch der Eingang des NAND-Glies 24 im Master-Kippglied 40′ der ersten Schieberegisterstufe SRS1 positiv wird, wenn er es nicht schon bereits ist, um bei gleichzeitigem Auftreten eines Master-Taktgebungsimpulses auf Master-Taktgebungsimpulsleitung 9, wie im Impulsdiagramm nach Fig. 5 ersichtlich, einen negativen Ausgang bereitzustellen. Ist der Prüfeinstellimpuls am Anschluss 8A abgeklungen, so dass nurmehr der verlängerte Prüfeinstellimpuls an der Anschlussklemme 8B anliegt, dann ist der betreffende Eingang am NAND-Glied 44 negativ, so dass dann auch dessen Ausgang positiv wird. Da zu diesem Zeitpunkt kein Prüfeinstellimpuls mehr am Anschluss 8A wirksam ist, ist damit auch der andere Eingang des Ausgangs-NAND-Glieds 46 im Prüfschaltnetz 5′ positiv, so dass der Ausgang des NAND-Glieds 46 negativ ist und damit durch den negativen Eingang am NAND-Glied 24 im Master-Kippglied 40′ der ersten Schieberegisterstufe SRS1 ein positiver Ausgang entsteht. Gleichzeitig jedoch wird über Zuleitung 81 ein invertierter Master-Taktgebungsimpuls auf das NAND-Glied 26 im Master-Kippglied 40′ der ersten Schieberegisterstufe SRS1 übertragen, so dass dann alle Eingänge des im Master-Kippglied 40′ weiterhin enthaltenen NAND-Gliedes 27 positiv sind, da ja durch den fehlenden Systemtaktgebungsimpuls über Leitung 84 der Ausgang des NAND-Gliedes 25 ebenfalls positiv ist und der Schaltzustand der Schieberegisterstufe gegenüber zuvor gewechselt hat.

Auch hier wiederum wird vor der Einwirkung des zweiten Master-Taktgebungsimpulses durch die Wirkung des Slave-Taktgebungsimpulses der Zustand des Master-Kippglieds 40 auf das Slave-Kippglied 50 übertragen, so dass beim Anliegen des zweiten Master-Taktgebungsimpulses auf Master-Taktgebungsimpulsleitung 9 gleichzeitig mit der Eingabe des gegenüber zuvor gewechselten Bitwertes in die Schieberegisterstufe SRS1 der ursprünglich hierin vorhanden gewesene Bitwert in die zweite Schieberegisterstufe SRS2 übertragen wird, so dass dann auch hier nach beendigter Prüfeinstellung die beiden ersten Schieberegisterstufen eines Schieberegistersegmentes sich in zueinander entgegengesetztem Schaltzustand befinden.

Falls es aus irgendwelchen Gründen vorteilhaft sein könnte, Taktgebungsimpulse beim Durchführen des Prüfeinstellverfahrens gemäss der Erfindung nicht von aussen zuführen zu müssen, lassen sich diese auch unter entsprechender Erweiterung des Prüfschaltnetzes 5 oder 5′ aus den zugeführten Prüfschaltimpulsen selbst ableiten. Hierzu können in an sich bekannter Weise Multivibratorketten mit entsprechenden Ausgängen oder auch freilaufende, im Impulseinsatz auslösbare Impulsgeneratoren dienen. Ein näheres Eingehen hierauf erübrigt sich, da entsprechende Schaltungen an sich ebenfalls als bekannt vorausgesetzt werden dürften.

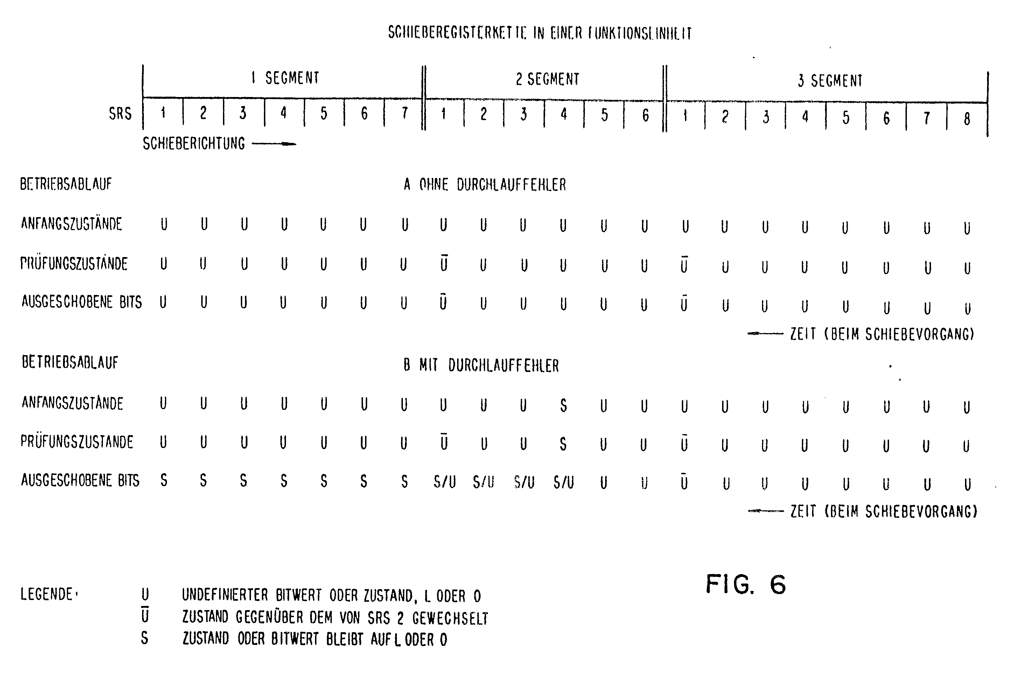

Aufgrund obenstehender Ausführungen lässt sich nunmehr der Vorgang des erfindungsgemäss ablaufenden Prüfungsverfahrens einer digitalen Funktionseinheit anhand des Schemas in Fig. 6 im einzelnen erläutern. Hierin ist oben die Schieberegisterkette schematisch aufgetragen und zwar so, wie sie sich mit den einzelnen Segmenten in Hintereinanderschaltung ergibt, wobei die einzelnen Schieberegisterstufen in diesen Segmenten numerisch angedeutet sind. Hierunter ist schematisch der Betriebsablauf einmal ohne Durchlauffehler und einmal mit Durchlauffehler aufgetragen. Bei den Anfangszuständen der Schieberegisterstufen sind die Bitwerte zunächst undefiniert, da als unbekannt vorausgesetzt ist, welche der Stufen den Zustand L oder den Zustand O einnimmt. Die Sachlage ändert sich, wenn nach Einstellung der Prüfungszustände in den ersten beiden Schieberegisterstufen SRS1 und SRS2 eines jeden Segmentes dort ein jeweils entgegengesetzter Zustand vorliegt.

Für das erste Segment ist, wie ersichtlich, kein Zustandswechsel angedeutet. Offensichtlich würde ja auch ein derartiger Zustandswechsel nichts zur Prüfung beitragen, da dieser Wechsel als letzter aus dem gesamten Schieberegister ausgeschoben wird und das Betriebsverhalten des ersten Schieberegistersegmentes in der Segmentfolge durch den Zustandswechsel der beiden ersten Schieberegisterstufen SRS1 und SRS2 des zweiten Segments beim Ausschieben überwacht wird. Wenn demgemäss also ein Prüfschaltnetz im ersten Schieberegistersegment in keiner Weise einen sinnvollen Beitrag bei Durchführung des Prüfungsverfahrens zu leisten vermag, so könnte es doch aus verschiedenen anderen Gründen zweckmässig sein, ein solches Prüfschaltnetz vorzusehen, und wenn es sich nur um gewisse Vereinheitlichungsbestrebungen bei der Segmentausführung handeln sollte.

Unterhalb der Prüfzustände sind in der Tabelle nach Fig. 6 die ausgeschobenen Bits angegeben, die unter der Voraussetzung keines Durchlauffehlers im zu prüfenden Schieberegister durch die Schaltzustandswechsel der beiden ersten Schieberegisterstufen SRS1 und SRS2 alle Segmente in der ausgeschobenen Impulsfolge erkennen lassen.

Im Teil B der Tabelle.nach Fig. 6 wird ein Durchlauffehler in der vierten Schieberegisterstufe SRS4 im zweiten Schieberegistersegment angenommen, welcher hier durch S gekennzeichnet ist. Während in diesem Falle der Schaltzustandswechsel im dritten Segment beim Ausschieben der Schieberegisterkette noch erfasst wird, ergibt sich für das zweite Segment ab der vierten Schieberegisterstufe SRS4 ein Durchlauffehler, der zwar zunächst noch nicht eindeutig erkennbar ist und erst als solcher klar auftritt, wenn sich der nächste Schaltzustandswechsel, nämlich der in den beiden ersten Schieberegisterstufen SRS1 und SRS2 des zweiten Segmentes, auf die ausgeschobenen Bits des ersten Schieberegistersegmentes auswirkt. Dadurch, dass infolgedessen der Zustand oder Bitwert in der Bitfolge am Schiebeausgang immer auf L oder O bleibt, lässt sich also die eindeutige Aussage machen, dass das nachfolgende Schieberegistersegment, nämlich das zweite, fehlerhaft ist.

Hieraus lässt sich erkennen, dass dank der Erfindung durch einfaches Abzählen der Bits ein fehlerhaftes Schieberegistersegment zu erfassen ist, indem einfach die Gleichheit bzw. Ungleichheit der Bitwerte der jeweiligen beiden ersten Schieberegisterstufen SRS1 und SRS2 aller Schieberegistersegmente in der Bitfolge am Schiebeausgang überwacht werden. Mit Hilfe von an nachgeschalteten Zählern angeordneten Vergleichern lassen sich entsprechende Anzeige-Ausgangssignale ableiten, so dass eine Fehlerüberwachung auch leicht zu automatisieren ist.

**Patentansprüche**

1. Verfahren zur Prüfung von monolithisch integrierten Halbleiterschaltungen, die sich aus mehreren minimalen austauschbaren Baueinheiten zusammensetzen, in denen sämtliche hierin neben Schaltnetzen enthaltenen Speicherglieder zu jeweils aus einem Schieberegister bestehenden Segmenten zusammenfassbar sind, wobei die Hintereinanderschaltung aller Segmente zusammen mit hierzu erforderlichen Takt- und Schiebeleitungen ein Schieberegister mit gemeinsamem Schiebeein- und -ausgang darstellt, so dass mittels zugeführter Schiebeimpulse Betriebsbereitschaft oder gegebenenfalls Durchlauffehler innerhalb der Schieberegister zu erfassen sind, dadurch gekennzeichnet,
- dass gleichzeitig zumindest allen Schieberegistersegmenten (2B bis 2D), die einem ersten Schieberegistersegment (2A) folgen, sich ausschliesslich auf deren beide ersten Schieberegisterstufen (SRS1, SRS2) auswirkende Prüfeinstellimpulse zugeführt werden, so dass im Ansprechen hierauf beide Stufen (SRS1, SRS2) zueinander entgegengesetzte Schaltzustände einnehmen,
- dass anschliessend auf den Schiebeeingang (6) Schiebeimpulse zum Ausschieben des gesamten Schieberegisters übertragen werden,
- dass bei Bekanntsein der in jedem Schieberegistersegment (2A, 2B, 2C oder 2D) enthaltenen Schieberegisterstufenanzahl während des Ausschiebevorgangs die Bitfolge auf der Schiebeausgangsleitung (12) auf Bitgleichheit der Schaltzustände jeweils beider ersten Schieberegisterstufen (SRS1, SRS2) aller Schieberegistersegmente (2A, 2B, 2C und 2D) zur Auslösung eines Fehlersignals überwacht wird, und
- dass, gegebenenfalls durch Abzählen, in der Bitfolge auf der Schiebeausgangsleitung (12) das fehlerhafte Schieberegistersegment (2A, 2B, 2C oder 2D) im Ansprechen darauf angezeigt wird.

2. Verfahren nach Anspruch 1, dadurch gekennzeichnet, dass bei Verwendung von in an sich bekannter Weise zu Master-Slave-Flipflops (40, 50) ergänzten Schieberegisterstufen die Prüfeinstellimpulse über ein jeweils am Schieberegistersegmenteingang vorgesehenes Prüfschaltnetz (5) in Serieneingabe zugeführt werden, um im Zusammenwirken mit den an die Master-Kippglieder (40) und an die Slave-Kippglieder (50) in an sich bekannter Weise je besonders angelegten, bei gleicher Folgefrequenz jedoch zueinander um 180° versetzten Master- und Slave-Taktimpulsfolgen auf die beiden ersten Schieberegisterstufen (SRS1, SRS2) jedes Schieberegistersegment (2A, 2B, 2C oder 2D) zur Einwirkung gebracht zu werden, indem die Prüfeinstellimpulsdauer die Zeitspanne höchstens zweier Master-Taktimpulse, gegebenenfalls einschliesslich dazwischen liegender Impulspause, derart einschliesst, dass in jedem Falle der nächst folgende Slave-Taktimpuls ausserhalb der genannten Zeitspanne zu liegen kommt.

3. Verfahren nach Anspruch 1 und/oder Anspruch 2, dadurch gekennzeichnet, dass der Einsatz der Master- und Slave-Taktimpulsfolgen mittels eines besonderen Schaltgliedes im Prüfschaltnetz (5) bei Zuführung des Prüfeinstellimpulses ausgelöst wird.

4. Anordnung zur Durchführung des Verfahrens nach den Ansprüchen 1 bis 3, dadurch gekennzeichnet, dass das Prüfschaltnetz (5) aus einem ersten (23) und einem zweiten (22), am Master-Kippglied (40) der ersten Schieberegisterstufe (SRS1) eines Segmentes (2A, 2B, 2C oder 2D) liegenden NAND-Glied besteht, wobei die beiden Eingänge des ersten NAND-Gliedes (23) einmal mit dem Slave-Kippglied-Ausgang der ersten Schieberegisterstufe (SRS1) und zum anderen mit einer an einem Anschluss (8) liegenden Prüfeinstellimpulsleitung verbunden sind, die einen Prüfeinstellimpuls mit einer grössenordnungsmässig der Master-Taktimpulsdauer entsprechenden Dauer überträgt, und die beiden Eingänge des zweiten NAND-Gliedes (22) je über ein NICHT-Glied (20, 21), nämlich ein erstes und ein zweites, einmal an die mit dem Anschluss (8) verbundene Prüfeinstellimpulsleitung und zum anderen an die mit dem Schiebeeingang (6) verbundene Schiebeleitung angeschlossen sind, so dass bei unerregter Schiebeleitung in Abhängigkeit vom aus der ersten Schieberegisterstufe (SRS1) in die zweite Schieberegisterstufe (SRS2) verschobenen Bitwert der hierzu komplementäre Bitwert in der ersten Schieberegisterstufe (SRS1) gesetzt wird.

5. Anordnung zur Durchführung des Verfahrens nach den Ansprüchen 1 bis 3, dadurch gekennzeichnet, dass ein das Master-Kippglied (40') der durch den Prüfeinstellimpuls angesteuerten ersten Schieberegisterstufe (SRS1) beaufschlagendes drittes NAND-Glied (46) bezüglich seines ersten Eingangs über ein drittes NICHT-Glied (42) an einer mit einem ersten Anschluss (8A) verbundenen Prüfeinstellimpulsleitung, deren hierüber zugeführter erster Prüfeinstellimpuls in seiner Dauer grössenordnungsmässig einem Master-Taktimpuls entspricht, und mit seinem zweiten Eingang am Ausgang eines vierten NAND-Glieds (44) liegt, dessen erster Eingang über ein viertes NAND-Glied (43) an eine mit einem zweiten Anschluss (8B) verbundene Prüfeinstellimpulsleitung, deren hierüber zugeführter zweiter Prüfeinstellimpuls in seiner Dauer grössenordnungsmässig der Zeitspanne, gebildet aus zwei Master-Taktimpulsen mit hiervon eingeschlossener Impulspause, entspricht, und dessen zweiter Eingang an die Klemme (6) der Schiebeleitung (11) angeschlossen sind, so dass unabhängig von der Vorgeschichte beider ersten Schieberegisterstufen (SRS1, SRS2) eines Segmentes (2A, 2B, 2C oder 2D) bei unerregter Schiebeleitung (11) jeweils die erste Schieberegisterstufe (SRS1) sowohl zunächst dank koinzidierender Wirkung eines entsprechenden Impulsanteils des am zweiten Anschluss (8B) anliegenden zweiten Prüfeinstellimpulses mit dem ersten Master-Taktimpuls sowie mit dem am ersten Anschluss (8A) anliegenden ersten Prüfeinstellimpuls in den ersten Zustand geschaltet wird, der mit nachfolgendem Slave-Taktimpuls vom zugeordneten Slave-Kippglied (50) in Form eines entsprechenden Bitwerts übernommen wird, um beim zweiten Master-Taktimpuls auf die zweite Schieberegisterstufe (SRS2) übertragen zu werden, als auch während der Impulsdauer des zweiten Master-Taktimpulses im anschliessenden koinzidierenden Zeitintervall des am ersten (8A) und am zweiten Anschluss (8B) anliegenden ersten und zweiten Prüfeinstellimpulses in den Zustand entsprechend dem gegenüber dem in die zweite Schieberegisterstufe (SRS2) zugeschobenen Bitwert komplementären Bitwert gesetzt wird.

**Claims**

1. Method of testing monolithically integrated semiconductor circuits composed of several minimum replaceable units where all storage elements contained therein together with combinational circuits can be assembled into segments each consisting of one shift register, the series arrangement of all segments together with clock and shift lines required for that purpose representing a shift register with common shift input and output so that by means of applied shift pulses the readiness for operation, or if necessary stuck faults in the shift registers are to be detected, characterized in
- that at least to all those shift register segments (2B to 2D) that follow a first shift register segment (2A) test circuit forming pulses influencing their two first shift register stages (SRS1, SRS2) exclusively are simultaneously applied, so that in response thereto both stages (SRS1, SRS2) adopt switching states opposite to each other,
- that subsequently shift pulses are transmitted to the shift input (6) for shifting out the entire shift register,
- that when the number of shift register stages in each shift register segment (2A, 2B, 2C or 2D) is known the bit sequence on the shift output line (12) is controlled during the shift-out process for bit equality of the switching states of the first two respective shift register stages (SRS1, SRS2) of all shift register segments (2A, 2B, 2C and 2D) for realising an error signal,
– and that, if necessary by counting, the error-containing shift register segment (2A, 2B, 2C or 2D) in the bit sequence on the shift output line (12) is indicated in response thereto.

2. Method as claimed in claim 1, characterized in that when shift register stages supplemented in a manner known per se into master-slave flipflops (40, 50) are used in test circuit forming pulses are serially applied via a test combinational circuit (5) respectively provided at the shift register segment input, in order to act in combination with the master and slave-clock pulse sequences separately applied in a known manner to the master flipflops (40) and to the slave flipflops (50) but shifted with respect to each other by 180° with the same following frequency, on the two first shift register stages (SRS1, SRS2) of each shift register segment (2A, 2B, 2C or 2D), in that the period of the test circuit forming pulse comprises the time of at the most two master-clock pulses, possibly including a pulse pause therebetween, in such a manner that in each case the following slave-clock pulse is outside the above mentioned period.

3. Method as claimed in claim 1 and/or claim 2, characterized in that the use of the master and slave-clock pulse sequences is initiated by means of a specific switching element in the test combinational circuit (5) upon the applying of the test circuit forming pulse.

4. Arrangement for carrying out the method as claimed in claims 1 to 3, characterized in that the test combinational circuit (5) consists of a first (23) and a second (22) NAND-element applied to the master flipflop (40) of the first shift register stage (SRS1) of a segment (2A, 2B, 2C or 2D), the two inputs of the first NAND-element (23) being connected on the one hand to the slave flipflop output to the first shift register stage (SRS1), and on the other to a test circuit forming pulse line applied to a connection (8), said test circuit forming pulses line transferring a test circuit forming pulse of a duration corresponding to that of the master-clock pulse, and that the two inputs of the second NAND-element (22) are respectively connected via an inverter (20, 21), i.e. a first and a second, to the test circuit forming pulse line connected to terminal (8), as well as to the shift line connected to the shift input (6), so that with a non-energized shift line, as a function of the bit value shifted from the first shift register stage (SRS1) into the second shift register stage (SRS2), the bit value complementary thereto is set in the first shift register stage (SRS1).

5. Arrangement for carrying out the method as claimed in claims 1 to 3, characterized in that a third NAND-element (46) applying the master flipflop (40') of the first shift register stage (SRS1) addressed by the test circuit forming pulse is applied with respect to its first input via a third inverter (42) to a test circuit forming pulse line connected to a first contact (8A), the first test circuit forming pulse thus applied corresponds in its duration to a master-clock pulse, and that with its second input it is applied to the output for a fourth NAND-element (44) whose first input is connected via a fourth inverter (43) to a test circuit forming pulse line connected to a second contact (8B) whose second test circuit forming pulse thus applied corresponds in its duration to the period formed of two master-clock pulses comprising a pulse pause, and whose second input is connected to the terminal (6) of the shift line (7) so that independently of the history of the two first shift register stages (SRS1, SRS2) of a segment (2A, 2B, 2C or 2D) with a non-energized shift line (11) the first respective shift register stage (SRS1), owing to a coincident effect of a corresponding pulse part of the second test circuit forming pulse applied to the second contact (8B) with the first master-clock pulse, and with the test circuit forming pulse at the first terminal (8A), is switched into the first state which with the following slave-clock pulse is adopted by the associated slave flipflop (50) in the form of a corresponding bit value for being transferred at the second master-clock pulse to the second shift register stage (SRS2), as well as switched into the state which corresponds to the bit value complementary to the bit value shifted to the second shift register stage (SRS2), said switching taking place during the second master-clock pulse in the subsequent coincident interval of the first and second test circuit forming pulse applied to the first (8A) and second terminal (8B).

**Revendications**

1. Procédé pour tester des circuits semiconducteurs intégrés monolithiques composés de plusieurs composants remplaçables, dans lesquels tous les éléments de mémoire et les circuits combinatoires peuvent être assemblés en segments constituant chacun un registre à décalage, le montage en série de tous les segments avec les lignes de chronologie et de décalage requises représentant un registre à décalage ayant une entrée et une sortie de décalage communes, de sorte que l'application des impulsions de décalage permette de détecter l'état de fonctionnement ou éventuellement des erreurs de passage des registres à décalage, caractérisé en ce que:
– on applique simultanément au moins à tous ceux des segments de registre à décalage (2B à 2D) faisant suite à un premier segment de registre à décalage (2A) des impulsions de test affectant exclusivement les deux premiers étages de registre à décalage (SRS1, SRS2) de ceux-ci, de sorte qu'en réponse à ceux-ci, les deux étages (SRS1, SRS2) ont des états de commutation opposés,
– on applique ensuite à l'entrée de décalage (6) des impulsions de décalage pour décaler vers l'extérieur le registre à décalage en entier,
– on teste durant le processus de décalage vers l'extérieur, lorsqu'on connaît le nombre d'étages de registre à décalage contenus dans chacun des segments de registre à décalage (2A, 2B, 2C ou 2D), la séquence de bits sur la ligne de sortie de décalage (12) pour détecter l'égalité de bits des états de commutation de chacun des deux premiers étages de registre à décalage (SRS1, SRS2) de tous les segments de registre à décalage (2A, 2B, 2C et 2D) pour émettre un signal d'erreur, et
– on indique en réponse à ceci, éventuellement en comptant, dans la séquence de bits sur la ligne de sortie de décalage (12) le segment de registre à décalage défectueux (2A, 2B, 2C ou 2D).

2. Procédé selon la revendication 1, caractérisé en ce que, lorsque les étages de registre à décalage sont réalisés, d'une façon connue en soi, à l'aide de bascules maître-esclave (40, 50), on applique en série les impulsions de test à travers un circuit combinatoire de bits (5) prévu à l'entrée du segment de registre à décalage, afin d'agir sur les deux premiers étages de registre à décalage (SRS1, SRS2) de chaque segment de registre à décalage (2A, 2B, 2C ou 2D) en coopération avec les séquences d'impulsion de chronologie maître et esclave appliquées séparément de façon connue aux bascules maître (40) et aux bascules esclave (50) mais décalées de 180° l'une part rapport à l'autre, à la même fréquence, et en ce que la durée de l'impulsion de test comprend au plus la durée de deux impulsions de chronologie maître, y compris éventuellement l'intervalle d'impulsions de telle sorte que dans chaque cas l'impulsion de chronologie esclave suivante se trouve à l'extérieur de la durée de temps mentionnée.

3. Procédé selon la revendication 1 et/ou la revendication 2, caractérisé en ce que l'utilisation des séquences d'impulsions de chronologie maître et esclave est initiée au moyen d'un élément de commutation spécial dans le circuit combinatoire de test (5) par application de l'impulsion de test.

4. Dispositif pour réaliser le procédé selon les revendications 1 à 3, caractérisé en ce que le circuit combinatoire de test (5) est composé d'un premier (23) et d'un second (22) élement et appliqué à la bascule maître (40) du premier étage de registre à décalage (SRS1), d'un segment (2A, 2B, 2C ou 2D), les deux entrées du premier élément ET (23) étant d'une part connectées à la sortie de la bascule esclave du premier étage de registre à décalage (SRS1), et d'autre part à une ligne d'impulsion de test connectée à une connexion (8), ladite ligne transférant une impulsion de test d'une durée de l'ordre de grandeur de la durée de l'impulsion de chronologie maître, et les deux entrées du second élement ET (22) étant d'une part connectées chacune à travers un inverseur (20, 21), c'est-à-dire un premier et un deuxième, à la ligne d'impulsion de test connectée à la connexion (8) et d'autre part à la ligne de décalage connectée à l'entrée de décalage (6), de telle sorte qu'en cas d'une ligne de décalage non excitée, et en fonction de la valeur de bit décalée à partir du premier étage de registre à décalage (SRS1) dans le second étage de registre à décalage (SRS2), la valeur de bit complémentaire est placée dans le premier étage de registre à décalage (SRS1).

5. Dispositif pour réaliser le procédé selon les revendications 1 à 3, caractérisé en ce qu'un troisième élément ET (46) commandant l'élément de bascule maître (40') du premier étage de registre à décalage (SRS1) adressé par l'impulsion de test est connecté par sa première entrée à travers un troisième inverseur (42) à une ligne d'impulsion de test connectée à la première connexion (8A), la première impulsion de test appliquée correspondant dans sa durée à l'ordre de grandeur d'une impulsion de chronologie maître, et connectée par sa seconde entrée à la sortie d'un quatrième élément ET (44) dont la première entrée est connectée à travers un quatrième inverseur (43) à une ligne d'impulsion de test connectée à une seconde connexion (8B), dont la seconde impulsion de test appliquée correspond dans sa durée à l'ordre de grandeur de la durée de deux impulsions de chronologie maître y compris l'intervalle d'impulsion et dont la seconde entrée est connectée à la borne (6) de la ligne de décalage (7) de sorte qu'indépendamment du passé des deux premiers étages de registre à décalage (SRS1, SRS2) d'un segment (2A, 2B, 2C ou 2D) avec une ligne de décalage non excitée (11), le premier étage de registre à décalage (SRS1) est placé dans un premier état, grâce à la coïncidence entre une partie d'impulsion correspondante de la seconde impulsion de test appliquée à la seconde connexion (8B) et la première impulsion de chronologie maître ainsi que la première impulsion de test appliquée à la première connection (8A), ledit premier état étant adopté, à l'impulsion de chronologie esclave suivante, par la bascule esclave associée (50) sous forme d'une valeur de bit correspondante pour être transferé au second étage de registre à décalage (SRS2) lors de la seconde impulsion de chronologie maître, et pour être commuté dans cet état correspondant à la valeur de bit complémentaire par rapport à la valeur de bit décalée vers le second étage de registre à décalage (SRS2), cette commutation ayant lieu durant la seconde impulsion de chronologie maître dans l'intervalle de temps coïncidant ultérieur, des première et seconde impulsions de test appliquées aux première (8A) et seconde (8B) connexions.

# FIG. 1

# FIG. 3

FIG. 2

FIG. 4

FIG. 5

SCHIEBEREGISTERKETTE IN EINER FUNKTIONSEINHEIT

| | | 1 SEGMENT | | | | | | | 2 SEGMENT | | | | | | 3 SEGMENT | | | | | | | |
|---|---|---|---|---|---|---|---|---|---|---|---|---|---|---|---|---|---|---|---|---|---|---|
| SRS | 1 | 2 | 3 | 4 | 5 | 6 | 7 | 1 | 2 | 3 | 4 | 5 | 6 | 1 | 2 | 3 | 4 | 5 | 6 | 7 | 8 |

SCHIEBERICHTUNG ⟶

**BETRIEBSABLAUF**      A OHNE DURCHLAUFFEHLER

| ANFANGSZUSTÄNDE | U | U | U | U | U | U | U | U | U | U | U | U | U | U | U | U | U | U | U | U | U |
|---|---|---|---|---|---|---|---|---|---|---|---|---|---|---|---|---|---|---|---|---|---|
| PRÜFUNGSZUSTÄNDE | U | U | U | U | U | U | U | $\bar{U}$ | U | U | U | U | U | $\bar{U}$ | U | U | U | U | U | U | U |
| AUSGESCHOBENE BITS | U | U | U | U | U | U | U | $\bar{U}$ | U | U | U | U | U | $\bar{U}$ | U | U | U | U | U | U | U |

⟶ ZEIT (BEIM SCHIEBEVORGANG)

**BETRIEBSABLAUF**      B MIT DURCHLAUFFEHLER

| ANFANGSZUSTÄNDE | U | U | U | U | U | U | U | U | U | U | S | U | U | U | U | U | U | U | U | U | U |
|---|---|---|---|---|---|---|---|---|---|---|---|---|---|---|---|---|---|---|---|---|---|
| PRÜFUNGSZUSTÄNDE | U | U | U | U | U | U | U | $\bar{U}$ | U | U | S | U | U | $\bar{U}$ | U | U | U | U | U | U | U |
| AUSGESCHOBENE BITS | S | S | S | S | S | S | S | S/U | S/U | S/U | S/U | U | U | $\bar{U}$ | U | U | U | U | U | U | U |

⟶ ZEIT (BEIM SCHIEBEVORGANG)

LEGENDE:

U    UNDEFINIERTER BITWERT ODER ZUSTAND, L ODER 0  
$\bar{U}$    ZUSTAND GEGENÜBER DEM VON SRS 2 GEWECHSELT  
S    ZUSTAND ODER BITWERT BLEIBT AUF L ODER 0

FIG. 6